Europäisches Patentamt

European Patent Office

Office européen des brevets

(19)

(11) Numéro de publication: **0 170 554**
**A1**

(12) ## DEMANDE DE BREVET EUROPEEN

(21) Numéro de dépôt: **85401249.9**

(22) Date de dépôt: **21.06.85**

(51) Int. Cl.⁴: **G 01 R 19/04**

(30) Priorité: **29.06.84 FR 8410351**

(43) Date de publication de la demande:
**05.02.86 Bulletin 86/6**

(84) Etats contractants désignés:
**DE FR GB IT**

(71) Demandeur: **SAPHYMO-STEL**
**29, avenue Carnot**
**F-91300 - Massy(FR)**

(72) Inventeur: **Frot, Dominique**
**THOMSON-CSF SCPI 173 bld Haussmann**
**F-75379 Paris Cedex 08(FR)**

(74) Mandataire: **Grynwald, Albert et al,**
**THOMSON-CSF SCPI 173, Bld Haussmann**
**F-75379 Paris Cedex 08(FR)**

(54) **Détecteur de la valeur de crête d'un signal périodique.**

(57) Circuit de détection de la valeur de crête d'un signal périodique (!Ue!).

Le signal (!Ue!) est retardé d'une durée ($\zeta$) de faible valeur par rapport à la période. L'amplitude du signal (!Uel) est comparée à celle du signal retardé ($U_c$). L'amplitude commune ($U_s$) représente la valeur de crête du signal. Celle-ci est mémorisée grâce à un condensateur qui sert également à imposer le retard.

FIG_1

EP 0 170 554 A1

# DETECTEUR DE LA VALEUR DE CRETE
## D'UN SIGNAL PERIODIQUE.

L'invention est relative à un détecteur de la valeur de crête d'un signal périodique notamment un signal sinusoïdal pur ou à faible taux d'harmoniques.

L'amplitude maximale, ou valeur de crête, d'un signal variant en fonction du temps est un paramètre important pour un grand nombre de circuits électriques. En particulier le bon fonctionnement de la plupart des circuits n'est assuré que si la valeur de crête des signaux qui leurs sont appliqués ne dépasse pas une limite prédéterminée.

On sait que lorsqu'un signal variable en fonction du temps passe par un maximum, sa dérivée par rapport au temps est nulle. C'est pourquoi les détecteurs de valeur de crête connus jusqu'à présent comportent un dérivateur. Mais les circuits dérivateurs sont instables et générateurs de bruits.

L'invention remédie à cet inconvénient.

Elle est caractérisée en ce que le détecteur comporte : un circuit retardateur imposant au signal un retard de faible valeur par rapport à la période, un moyen pour comparer l'amplitude du signal à celle du signal retardé, un moyen pour détecter l'égalité entre ces amplitudes, et un moyen pour mémoriser l'amplitude commune, cette dernière représentant la valeur de crête du signal.

La précision de ce détecteur dépend de la valeur du retard. La précision est d'autant plus grande que le retard est faible.

Dans la réalisation préférée le signal dont on veut détecter la valeur de crête charge un condensateur par l'intermédiaire d'un inter rupteur qui est ouvert dès que la différence entre l'amplitude du signal et celle du signal retardé passe par zéro et ce condensateur de mémorisation est également utilisé pour imposer le retard.

De préférence la valeur de crête est mémorisée et le contenu de la mémoire correspondante est renouvelé à chaque période.

D'autres caractéristiques et avantages de l'invention apparaîtront avec la description de certains de ses modes de réalisation, celle-ci étant effectuée en se référant aux dessins ci-annexés sur lesquels :

- la figure 1 est un diagramme illustrant le principe sur lequel est basé le détecteur de valeur de crête selon l'invention,

- la figure 2 est un schéma sous forme de blocs, d'un détecteur de valeurs de crête échantillonnées,

- la figure 3 est un schéma de redresseur faisant partie du détecteur de la figure 2,

- la figure 4 montre les autres parties du détecteur de la figure 2,

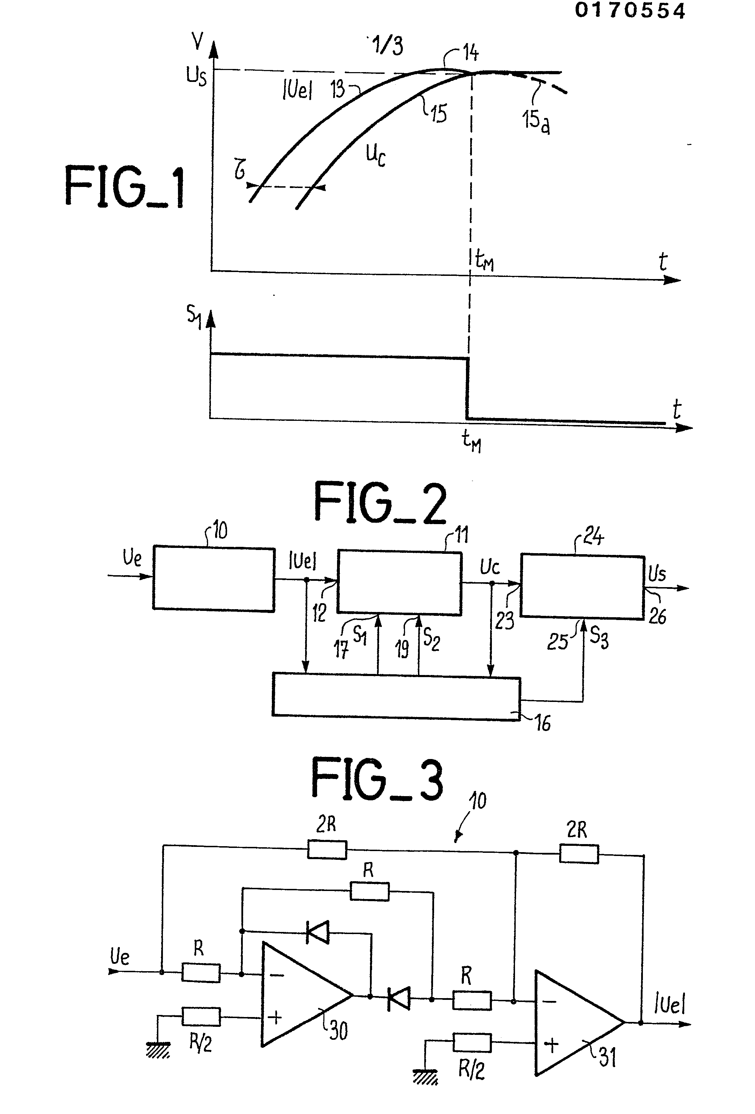

- les figures $5_a$ à $5_f$ sont des diagrammes de signaux du détecteur représenté sur les figures 2 à 4 et,

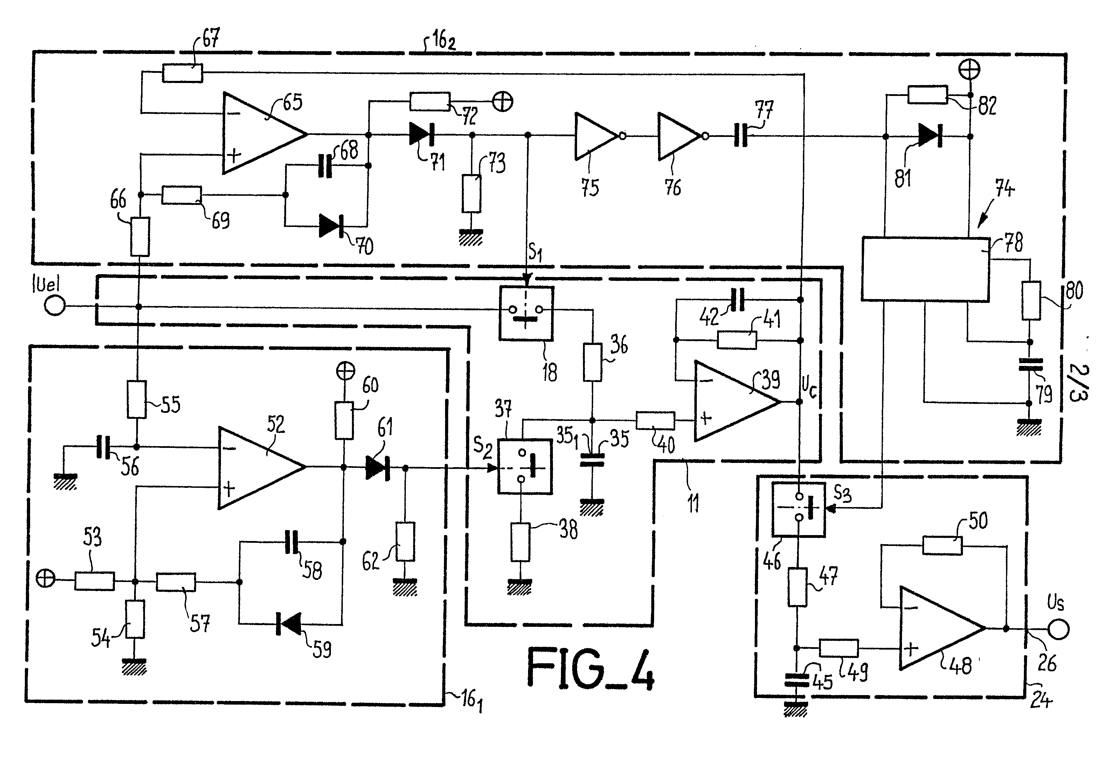

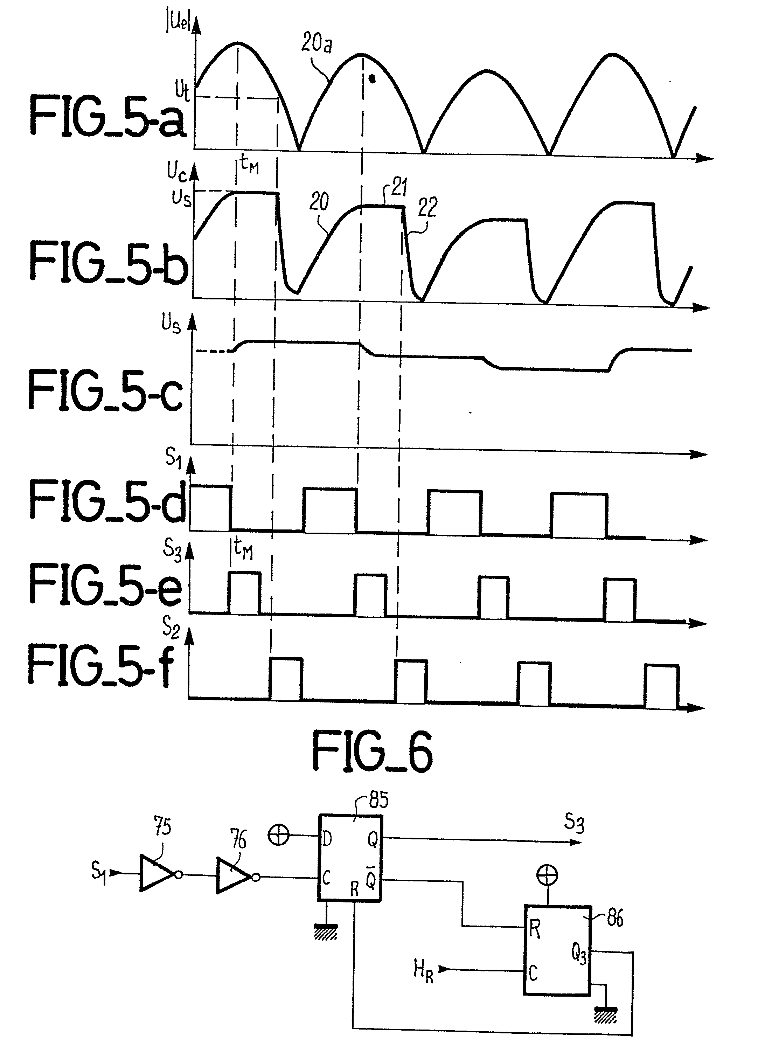

- la figure 6 est un schéma d'une variante d'une partie du circuit représenté sur la figure 4.

L'exemple qui va être décrit en relation avec les figures est un circuit de détection de valeurs de crête pour un signal sinusoïdal pur ou à faible taux d'harmoniques utilisable pour des fréquences comprises entre 300 Hz et 10 000 Hz. Ce signal sinusoïdal Ue est alternatif, c'est-à-dire qu'il est alternativement positif et négatif. C'est pourquoi le détecteur comporte, à son entrée, un redresseur des alternances négatives, ou détecteur de valeur absolue 10 (figures 2 et 3).

Le signal de valeur absolue, qui est noté | Ue| ,fourni par le détecteur 10, est appliqué sur l'entrée 12 d'un circuit 11 détecteur de crêtes. Ce circuit fournit sur sa sortie un signal $U_c$, avant que la crête soit atteinte, qui est identique au signal | Ue| mais avec un retard $\tau$ petit par rapport à la période du signal sinusoïdal | Ue| ; après la crête ce signal $U_c$ a une amplitude $U_s$ constante : celle de la crête.

Sur le diagramme de la figure 1 on a représenté par la courbe 13 les variations du signal $|Ue|$ en fonction du temps t au voisinage du maximum, ou crête, 14. La courbe 15 en traits pleins représente le signal $U_c$. La courbe $15_a$ en traits interrompus correspond au signal virtuel $|Ue|$ retardé de $\zeta$ après la crête.

Dans un séquenceur 16 on effectue la différence entre les amplitudes V des signaux $|Ue|$ et $U_c$. Quand cette différence $|Ue| - U_c$ passe par zéro le séquenceur 16 produit un signal $S_1$ sur une entrée 17 du circuit 11 permettant d'ouvrir un interrupteur 18 (figure 4) pour mémoriser la valeur commune $U_s$ des amplitudes des signaux $|Ue|$ et $U_c$ à cet instant $t_M$.

Le séquenceur 16 compare également le signal $|Ue|$ à un seuil $U_t$ (figure $5_a$). Lorsque $|Ue|$ descend au-dessous de ce seuil $U_t$ le séquenceur 16 produit un signal $S_2$ appliqué sur une entrée 19 du circuit 11 pour remettre à zéro la mémoire que contient ce dernier.

Le signal $U_c$ (figure $5_b$) sur la sortie du circuit 11 présente ainsi des parties ascendantes 20 identiques, au retard $\zeta$ près, aux parties correspondantes 20a du signal $|Ue|$, des paliers 21 d'amplitude $U_s$ (valeur de crête du signal $|Ue|$) suivis par des parties 22 à forte pente descendante.

Le signal $U_c$ est transmis à l'entrée 23 d'une mémoire 24 des valeurs de crêtes qui, grâce à un signal $S_3$ de commande - produit par le séquenceur 16 -appliqué sur son entrée 25 ne mémorise que les paliers 21. On obtient ainsi sur la sortie 26 de la mémoire 24 un signal, également noté $U_s$, quasiment continu mais dont la valeur, pratiquement égale au maximum du signal $|Ue|$, peut varier à chaque alternance de ce signal $|Ue|$.

On voit sur la figure 1 que le signal $U_s$ ne correspond pas exactement au sommet de la courbe 13 ou de la courbe 15, c'est-à-dire qu'il n'a pas exactement l'amplitude de la crête du signal. Toutefois la différence entre ce signal $U_s$ et la valeur de crête est faible et est acceptable pour la plupart des applications. De plus cette différence est d'autant plus faible que le retard $\zeta$ est petit.

Dans l'exemple représenté sur la figure 3 le redresseur 10 est formé d'un circuit classique de gain 1 qui comprend deux amplificateurs opérationnels 30 et 31. Le signal Ue est appliqué sur l'entrée inverseuse (-) de l'amplificateur 30 par l'intermédiaire d'une résistance de valeur R. L'entrée inverseuse est également reliée à l'entrée inverseuse (-) du second amplificateur opérationnel 31 par l'intermédiaire d'une résistance de valeur 2R. Une autre résistance de valeur 2R est disposée entre l'entrée inverseuse de l'amplificateur 31 et la sortie de ce dernier. L'entrée non inverseuse (+) de l'amplificateur 30 est reliée à la masse par l'intermédiaire d'une résistance de valeur $\frac{R}{2}$ . Il en est de même pour l'entrée correspondante de l'amplificateur 31. La sortie de l'amplificateur 30 est connectée, d'une part, à l'anode d'une première diode dont la cathode est reliée à son entrée inverseuse et, d'autre part, à la cathode d'une seconde diode dont l'anode est connectée à l'entrée inverseuse de l'amplificateur 31 par l'intermédiaire d'une résistance de valeur R. Enfin une autre résistance de valeur R est disposée entre la cathode de la première diode et l'anode de la seconde diode.

Le circuit 10 représenté sur la figure 3 délivre le signal $|Ue|$ , c'est-à-dire :

$$|Ue| = Ue \text{ si } Ue > 0$$
$$|Ue| = - Ue \text{ si } Ue < 0.$$

L'avantage, connu en soi, du circuit de la figure 3 est qu'il permet de s'affranchir des problèmes de seuil inhérents aux redresseurs classiques à pont de diodes.

Le circuit 11 de détection et mémorisation de la valeur de crête de $|Ue|$ comporte (figure 4) un condensateur 35 dont une armature est à la masse et dont l'autre armature $35_1$ reçoit le signal $|Ue|$ par l'intermédiaire, d'une part, de l'interrupteur statique 18 et, d'autre part, d'une résistance 36 en série. La seconde armature $35_1$ est également connectée à la masse par l'intermédiaire d'un second interrupteur statique 37 commandé par le signal $S_2$ (figures 2 et 5) en série avec une résistance 38. La tension aux bornes du condensateur 35 est transmise à l'entrée non inverseuse (+) d'un amplificateur opérationnel 39 par l'intermédiaire d'une résistance 40. La sortie de l'amplificateur opérationnel 39, sur laquelle apparaît le signal $U_c$ (figure $5_b$), est reliée à l'entrée inverseuse (-) par l'intermédiaire de l'ensemble en parallèle d'une résistance 41 et d'un condensateur 42.

Avant l'instant $t_M$ l'interrupteur 18 est fermé; de ce fait le condensateur 35 se charge au niveau du signal | Ue | avec un retard $\zeta$ qui dépend du filtre constitué par la résistance 36 de valeur $R_1$ et du condensateur 35 lui même, dont la capacité est $C_1$. Ce retard a la valeur :

$$\zeta = R_1 C_1.$$

Au cours de la charge du condensateur 35 l'interrupteur 37 est ouvert, ce qui évite la décharge. Cet interrupteur 37 est fermé, comme on le verra plus loin, par le signal $S_2$ (figure $5_f$) lorsque le signal | Ue | descend au-dessous du seuil $U_t$. A ce moment le condensateur 35 se décharge.

La valeur $R_1$ de la résistance 36 est choisie en fonction des critères suivants : d'une part elle doit être faible par rapport aux valeurs des résistances des interrupteurs 18 et 37 lorsqu'ils sont ouverts et par rapport à l'impédance d'entrée de l'amplificateur 39 pour ne pas affaiblir le signal emmagasiné par ledit condensateur 35; d'autre part la valeur $R_1$ doit être suffisamment élevée pour limiter le courant dans l'interrupteur 18.

Par ailleurs le condensateur $C_1$ doit présenter un faible angle de perte et une capacité élevée par rapport aux capacités parasites du circuit.

Les résistances 40 et 41 assurent une compensation des tensions et courants de décalage (ou offset) tandis que le condensateur 42, de faible capacité, quelques picofarads, stabilise l'amplificateur 39 pour lui permettre de suivre dans les meilleures conditions le signal de tension du condensateur 35.

Le circuit 24 de mémorisation des paliers 21 du signal $U_c$ en sortie du circuit 11 comporte un condensateur 45 de mémorisation relié à la sortie de l'amplificateur 39 par l'intermédiaire d'un interrupteur statique 46 sensible au signal $S_3$ (figures 2 et 5) et d'une résistance 47 de valeur $R_3$, en série avec l'interrupteur.

La borne commune au condensateur 45 et à la résistance 47 est connectée à l'entrée non inverseuse (+) d'un amplificateur opérationnel 48 par l'intermédiaire d'une résistance 49. La sortie de l'amplificateur 48, qui délivre le signal de sortie $U_s$ (figure $5_c$), est reliée à son entrée inverseuse (-) par l'intermédiaire d'une résistance 50 de même valeur que la résistance 49. Ces résistances 49 et 50 permettent, comme les résistances 40 et 41, une compensation des tensions et courants d'offset.

Le condensateur 45 est chargé par le signal $U_c$ quand l'interrupteur 46 est fermé sous la commande du signal $S_3$ (figure $5_e$). Le condensateur 45 conserve sa charge quand l'interrupteur 46 est ouvert. Cette charge est transmise sur la sortie 26 par l'intermédiaire de l'amplificateur 48 qui assure l'isolement. Elle n'est modifiée qu'après une nouvelle fermeture de l'interrupteur 46 pendant un temps déterminé suivant l'instant $t_M$.

Le séquenceur 16 comporte deux parties, à savoir une première partie $16_1$ qui engendre le signal $S_2$ de commande de l'interrupteur 37 et une seconde partie $16_2$ qui engendre les signaux $S_1$ et $S_3$ de commande des interrupteurs, respectivement 18 et 46.

La première partie $16_1$ du séquenceur 16 comprend un amplificateur opérationnel 52 monté en comparateur rapide; son état de sortie est fonction du signe de la différence entre les tensions appliquées sur ses bornes d'entrée.

Sur l'entrée non inverseuse (+) est appliquée la tension de consigne $U_t$ (figure $5_a$) grâce à un pont diviseur à deux résistances 53 et 54. Sur l'entrée inverseuse (-) est appliquée la tension $|U_e|$ par l'intermédiaire d'un filtre à résistance 55 et condensateur 56.

L'entrée non inverseuse est par ailleurs reliée à la première borne d'une résistance 57 dont la seconde borne est connectée à la sortie de l'amplificateur 52 à travers un condensateur 58 sur lequel se trouve en parallèle une diode 59 branchée dans un sens tel que son anode est reliée directement à la sortie de l'amplificateur 52. Cette sortie est en outre reliée à une source de potentiel de référence par l'intermédiaire d'une résistance 60 et à l'anode d'une diode 61 sur la cathode de laquelle apparaît le signal $S_2$. Cette cathode est également reliée à la masse par l'intermédiaire d'une résistance 62.

Le fonctionnement de l'étage $16_1$ est le suivant :

Si $|Ue| > U_t$, la tension de sortie de l'amplificateur 52 est une tension de saturation négative. Les diodes 59 et 61 sont donc bloquées. Il en résulte que le signal $S_2$ est 0 volt, du fait de la présence de la résistance 62. Dans ces conditions l'interrupteur 37 est ouvert.

Si $|Ue| < U_t$, la tension de sortie de l'amplificateur 52 est une tension de saturation positive. La diode 61 est donc passante et la signal $S_2$ est positif. L'interrupteur 37 est donc fermé.

Il est à noter que la présence du condensateur 58 permet d'accélérer la commutation d'un niveau de $S_2$ à l'autre et que la conduction de la diode 59 modifie légèrement la valeur de $U_t$. On a donc un effet d'hystérésis qui améliore la stabilité du comparateur.

Le second étage $16_2$ du séquenceur 16 comporte aussi un amplificateur opérationnel 65 monté en comparateur rapide, comme l'amplificateur 52.

Sur l'entrée non inverseuse (+) est appliqué le signal $|Ue|$ par l'intermédiaire d'une résistance 66. L'entrée inverseuse (-) est reliée à la sortie de l'amplificateur opérationnel 39, qui délivre le signal $U_c$, par l'intermédiaire d'une résistance 67.

La sortie de l'amplificateur 65 est ramenée à son entrée non inverseuse (+) via un condensateur 68 et une résistance 69 en série. Une diode 70 est en parallèle sur le condensateur 68 dans un sens tel que que sa cathode est reliée à la sortie de l'amplificateur 65. Cette dernière sortie est par ailleurs reliée à l'anode d'une autre diode 71.

8

ainsi qu'à un potentiel de référence via une résistance 72. La cathode de la diode 71 est reliée à la masse par l'intermédiaire d'une résistance 73. Cette cathode délivre le signal $S_1$ de commande de l'interrupteur 18.

La cathode de la diode 71 est reliée à l'entrée d'un monostable 74 par l'intermédiaire, d'une part, de deux inverseurs logiques en série 75 et 76, qui imposent un léger retard au signal qu'ils transmettent, et, d'autre part, d'un condensateur 77.

Le monostable 74 comporte un circuit intégré 78, par exemple celui du type NE 555, ainsi qu'un condensateur 79 et une résistance 80 qui fixent la constante de temps du monostable. Le circuit intégré 78 est également associé à une diode 81, en parallèle avec une résistance 82, et sur la cathode de laquelle est appliquée une tension de référence, l'anode recevant le signal d'entrée du monostable, à savoir le signal $S_1$. Le monostable est déclenché par le front descendant du signal $S_1$. Par contre, grâce à la diode 81, le front montant du signal $S_1$ n'est pas pris en compte par le circuit 78.

Si $|Ue| > U_c$ la sortie du comparateur 65 est une tension de saturation positive. Il en résulte que le signal $S_1$ est aussi positif et que l'interrupteur 18 est fermé. Ainsi le condensateur 35 se charge.

Dès que $|Ue| < U_c$, la sortie du comparateur 65 est une tension de saturation négative. La diode 71 se bloque. Le signal $S_1$ est alors nul du fait de la liaison à la masse par la résistance 73. L'interrupteur 18 est alors ouvert, la charge du condensateur 35 est interrompue. Sa valeur est maintenue au palier 21.

L'interrupteur 46, commandé par le signal $S_3$, qui transmet la charge du condensateur 35 au condensateur 45, n'est fermé que pendant un temps constant, déterminé par le monostable 74, après l'ouverture de l'interrupteur 18.

Sur la figure 6 on a représenté une variante, de type numérique, de l'ensemble formé par le monostable 74 et le condensateur 77.

Dans cette variante le signal de sortie de l'inverseur 76 est appliqué sur l'entrée C d'une bascule bistable 85 dont la sortie Q

délivre le signal $S_3$. La sortie $\bar{Q}$ de cette bascule est connectée à l'entrée R de remise à zéro d'un compteur 86 diviseur par 8. La sortie $Q_3$ de ce compteur 86 est reliée à l'entrée R de remise à zéro de la bascule 85. Le signal d'horloge $H_R$ est appliqué sur l'entrée C de comptage du compteur 86. Le comptage de signaux d'horloge démarre lorsque $\bar{Q}$ = 0. Quand $Q_3$ atteint la valeur 1, la bascule 85 est remise à 0. Il en résulte qu'alors $S_3$ = 0 et $\bar{Q}$ = 1, ce qui bloque le comptage.

Si, par exemple, le signal d'horloge appliqué sur l'entrée C du compteur 86 a une fréquence de 2 MHz le signal apparaissant sur sa sortie $Q_3$ a une fréquence huit fois plus faible. Ainsi le signal $S_3$ aura la valeur 1 pendant huit périodes du signal d'horloge; à cette durée il faut ajouter l'écart de temps séparant le passage par 0 de $\bar{Q}$ du premier front montant du signal d'horloge. La précision sur la durée du signal $S_3$ dépend de cet écart. Cette précision est généralement plus grande qu'avec le monostable du type représenté sur la figure 4.

0170554

## REVENDICATIONS

1. Circuit de détection de la valeur de crête d'un signal périodique (Ue), caractérisé en ce qu'il comporte un moyen (36, 35) pour retarder ce signal d'une durée ( $\tau$ ) de faible valeur par rapport à la période, un moyen ($16_2$) pour comparer l'amplitude du signal (Ue) à celle du signal retardé ($U_c$), un moyen pour détecter l'égalité entre ces amplitudes, et un moyen (35, 45) pour mémoriser l'amplitude commune ($U_s$), cette dernière représentant la valeur de crête du signal.

2. Circuit selon la revendication 1, caractérisé en ce que le moyen pour retarder le signal périodique comporte un condensateur (35) servant également à la mémorisation de la valeur de crête.

3. Circuit selon la revendication 2, caractérisé en ce que ledit condensateur (35) du moyen de retard est chargé par le signal d'entrée (Ue) par l'intermédiaire d'une résistance (36) et d'un interrupteur (18) qui s'ouvre, sous la commande du moyen comparateur ($16_2$), quand les amplitudes du signal périodique et du signal retardé sont égales.

4. Circuit selon la revendication 2 ou 3, caractérisé en ce qu'il comporte un circuit de décharge dudit condensateur (35) du circuit de retard et de mémorisation qui comporte un interrupteur (37) fermé lorsque l'amplitude du signal (Ue) tombe au-dessous d'un seuil prédéterminé ($U_t$).

5. Circuit selon l'une quelconque des revendications 2 à 4, caractérisé en ce que les moyens de mémorisation du signal de crête comportent un second condensateur (45) recevant la charge du premier condensateur (35) par l'intermédiaire d'un interrupteur (46) fermé, sous la commande des moyens comparateurs ($16_2$), pendant un temps déterminé suivant la détection de l'égalité entre l' amplitude du signal périodique et l'amplitude du signal retardé.

6. Circuit selon les revendications 3 et 5, caractérisé en ce que le signal ($S_3$) de commande de l'interrupteur (46) de charge du second condensateur (45) est fourni par un monostable (74) dont l'entrée reçoit le signal $(S_1)$ de commande de l'interrupteur (18) de charge du premier condensateur (35).

7. Circuit selon l'une quelconque des revendications précédentes, caractérisé en ce qu'étant destiné à la détection des valeurs de crête d'un signal alternatif, il comporte à son entrée un redresseur (10) ou détecteur de valeur absolue ( | Ue | ).

8. Circuit selon l'une quelconque des revendications précédentes, caractérisé en ce que le contenu de la mémoire contenant l'amplitude commune $(U_s)$ est renouvelé à chaque période.

9. Application du circuit selon l'une quelconque des revendications précédentes, à la détection des valeurs de crête d'un signal sinusoïdal pur ou à faible taux d'harmoniques.

# FIG_1

# FIG_2

# FIG_3

2/3

FIG_4

0170554

3/3

FIG_5-a

FIG_5-b

FIG_5-c

FIG_5-d

FIG_5-e

FIG_5-f

FIG_6

Office européen
des brevets

**RAPPORT DE RECHERCHE EUROPEENNE**

**0170554**
Numero de la demande

EP 85 40 1249

## DOCUMENTS CONSIDERES COMME PERTINENTS

| Catégorie | Citation du document avec indication. en cas de besoin. des parties pertinentes | Revendication concernee | CLASSEMENT DE LA DEMANDE (Int Cl 4) |
|---|---|---|---|
| Y | FR-A-2 433 757 (KRAUTKRAMER GmbH) <br> * Page 1, lignes 28-35; page 2, lignes 1-3, 30-33; pages 3,4, en entier; figures 2-3 * | 1 | G 01 R 19/04 |
| A | | 9 | |
| Y | DE-A-3 016 244 (VOLKSWAGENWERK AG) <br> * Pages 2-4, entier; figures * | 1-4 | |
| Y | ELECTRONIC ENGINEERING, vol. 40, septembre 1968, pages 485-487, Londres, GB; W.J. MUNDL: "Peak-reading instrument with instantaneous response for use at l.f." <br> * Figures 2-4; page 487, paragraphes 1-2 * | 1 | |
| Y | IDEM | 1-4 | DOMAINES TECHNIQUES RECHERCHES (Int. Cl.4) <br><br> G 01 R |
| A | IDEM | 6-9 | |
| A | DE-A-2 444 655 (SIEMENS AG) <br> * Figues 1,3 * | 5 | |

-/-

Le présent rapport de recherche a été établi pour toutes les revendications

| Lieu de la recherche <br> LA HAYE | Date d'achèvement de la recherche <br> 09-10-1985 | Examinateur <br> KAUFFMANN J. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur. mais publié à la date de dépôt ou après cette date
D : cité dans la demande
L : cité pour d'autres raisons

& : membre de la même famille, document correspondant

OEB Form 1503 03 82

Office européen
des brevets

**RAPPORT DE RECHERCHE EUROPEENNE**

EP 85 40 1249

| | | | |
|---|---|---|---|
| **DOCUMENTS CONSIDERES COMME PERTINENTS** | | | Page 2 |
| Catégorie | Citation du document avec indication, en cas de besoin, des parties pertinentes | Revendication concernée | CLASSEMENT DE LA DEMANDE (Int. CI 4) |
| A | US-A-4 311 960 (FRANK P. BARR)<br>* Figures 1,2; abstract; colonne 2, ligne 69 - colonne 3, lignes 1-40 * | 6 | |
| | ----- | | |
| | | | DOMAINES TECHNIQUES RECHERCHES (Int. CI.4) |
| | Le présent rapport de recherche a été établi pour toutes les revendications | | |

| Lieu de la recherche | Date d'achèvement de la recherche | Examinateur |
|---|---|---|
| LA HAYE | 09-10-1985 | KAUFFMANN J. |

OEB Form 1503 03 82